# FASCICULE DE BREVET EUROPEEN

(11) **EP 3 528 320 B1**
(45) Date de publication et mention de la délivrance du brevet: **21.10.2020**
(21) Numéro de dépôt: 19156330.3
(22) Date de dépôt: 11.02.2019
(51) Int. Cl.: H01M 4/04, H01M 4/1391, H01M 6/40, H01M 4/02

(54) **PROCEDE DE FABRICATION D'UNE ELECTRODE POSITIVE POUR MICROBATTERIE TOUT SOLIDE AU LITHIUM**
HERSTELLUNGSVERFAHREN EINER POSITIVEN ELEKTRODE FÜR FESTE LITHIUM-MIKROBATTERIE
METHOD FOR PRODUCING A POSITIVE ELECTRODE FOR A SOLID LITHIUM MICROBATTERY

(30) Priorité: 16.02.2018 FR 1851346
(43) Date de publication de la demande: 21.08.2019
(73) Titulaire: Commissariat à l'énergie atomique et aux énergies alternatives, 75015 Paris (FR)
(72) Inventeur: BEDJAOUI, Messaoud, 38054 GRENOBLE Cedex 09 (FR); AMIRAN, Johnny, 38054 GRENOBLE Cedex 09 (FR); LOPEZ, Nicolas, 38054 GRENOBLE Cedex 09 (FR)
(74) Mandataire: Brevalex

(56) Documents cités:
- WO-A1-2017/204859
- US-A1- 2015 221 974

## Description

### DOMAINE TECHNIQUE ET ÉTAT DE LA TECHNIQUE ANTÉRIEURE

La présente invention se rapporte au procédé de fabrication d'une électrode positive pour microbatterie tout solide au lithium.

Les microbatteries tout solides au lithium, d'une épaisseur inférieure à la centaine de micromètres, sont des microsystèmes flexibles présentant de bonnes performances électrochimiques (capacité volumique) et une longue durée de vie. Les microbatteries sont devenues, depuis quelques années, des composants incontournables dans de nombreux domaines et notamment pour le développement des systèmes intelligents embarqués. Elles trouvent, par exemple, des applications dans les domaines médicaux, spatiaux, de la sécurité (carte à puce, par exemple), de l'automobile, des microsystèmes électromécaniques (MEMs), des microcapteurs ou encore de la microélectronique.

Classiquement, les microbatteries comportent deux électrodes, une électrode positive (ou cathode) et une électrode négative (ou anode), séparées par un électrolyte solide isolant électronique mais conducteur ionique. Les électrodes sont électriquement connectées à des collecteurs de courant, de nature métallique, par exemple, en titane, platine ou tungstène. Une couche d'encapsulation protège les matériaux de l'air et de l'humidité. L'ensemble de ces couches minces est déposé sur un substrat.

Les microbatteries au lithium reposent sur le principe d'intercalation-désintercalation de l'ion lithium au sein des électrodes.

L'électrode positive est un conducteur mixte électronique et ionique (par exemple, LiCoO₂, TiOS, TiS₂, V₂O₅). L'électrolyte est un isolant électronique avec une forte conductivité ionique (LiPON). L'électrode négative comprend du lithium métallique ou des matériaux lithiés (Li-Si, ou Li-Ge par exemple).

L'électrode positive est l'un des éléments clefs dans la définition des performances électrochimique d'une microbatterie.

Classiquement, l'électrode positive, comme les autres couches actives, sont fabriquées par des techniques de dépôt de couches minces, comme le dépôt chimique en phase vapeur ou le dépôt physique en phase vapeur. Afin de réaliser des couches minces avec des motifs bien définis, les techniques de fabrication d'une microbatterie au lithium utilisent des technologies de masquage mécanique et/ou de photolithogravure.

Les technologies de masquage sont particulièrement adaptées aux composants de taille relativement grande (par exemple 1cmx1cm). Elles trouvent leurs limitations dans la conception des composants de taille très réduite (quelques mm²) en raison des difficultés d'alignement des différents niveaux de masque mais surtout de leurs inaptitudes à corriger les effets d'ombrage. En effet, il est généralement admis que l'utilisation des pochoirs ou masques mécaniques engendrent un effet d'ombrage sur les bords des motifs dégradant ainsi la précision de définition latérale des couches. Cette limitation peut être rédhibitoire dans la réalisation de composants de taille réduite (quelques mm²). De plus, le procédé de masquage mécanique nécessite l'emploi de plusieurs unités de masques dont la gestion (nettoyage, stockage, remplacement....) devient très lourde dans un processus industriel.

En ce qui concerne la photolithogravure, la définition géométrique des motifs est basée sur le principe de gravure des couches actives par voie chimique ou sèche à travers un masque temporaire de résine préalablement disposé en contact direct avec les couches actives. La couche de résine dont le rôle principal est de servir de masque de gravure est par la suite entièrement supprimée par voie chimique. Contrairement aux dépôts par masquage mécanique ou pochoir, les techniques de photolithographie permettent d'atteindre des résolutions à l'échelle du micron autorisant ainsi la conception de composants de taille millimétrique et micrométrique. L'une des difficultés techniques de la voie photolithographie concerne la non-compatibilité des étapes dépôt/gravure avec l'emploi de substrats fins et ultrafins. Par ailleurs, les procédés de photolithographie supposent la multiplication du nombre des étapes technologiques impactant ainsi le cout de réalisation des composants.

De plus, afin de répondre aux contraintes de miniaturisation tout en préservant les propriétés électrochimiques des microbatteries, la fabrication de la cathode nécessite souvent des épaisseurs relativement fortes (supérieures ou égale à 10µm) et implique parfois des étapes de post recuit thermique (au-delà de 400°C pendant plusieurs heures). Ainsi, la structuration de la couche cathodique par des voies standards faisant appel aux techniques de masquage mécanique, de photolithogravure ou laser devient problématique et notamment dans le cas de substrats fins et ultrafins.

### EXPOSÉ DE L'INVENTION

C'est, par conséquent, un but de la présente invention de proposer un procédé de fabrication d'une électrode positive bien définie, sur un substrat, de préférence fin ou ultrafin, et le procédé devant être facilement industrialisable.

Ce but est atteint par un procédé de réalisation d'une électrode positive pour microbatterie tout solide au lithium comprenant les étapes successives suivantes :
a) fourniture d'un substrat, de préférence fin ou ultrafin, et typiquement en céramique, en verre ou en silicium, le substrat étant recouvert localement par une couche métallique,
b) dépôt d'une couche cathodique en un matériau d'électrode positive, par exemple en oxyde mixte de lithium, la couche cathodique ayant une épaisseur typiquement supérieure à 1µm, une première partie de la couche cathodique recouvrant le substrat et une deuxième partie de la couche cathodique recouvrant la couche métallique,
c) réalisation d'un traitement thermique à une température supérieure ou égale à 400°C, sur la couche cathodique, de manière à cristalliser la deuxième partie de la couche cathodique pour former une électrode positive, et de manière à délaminer la première partie de la couche cathodique.

Par « délaminer », on entend que la première partie de la couche cathodique perd son adhésion provoquant son effritement par rapport à son substrat de support.

Le procédé selon l'invention permet d'obtenir une électrode positive dont le motif présente une définition accrue par rapport aux techniques de masquage de l'art antérieur. Le procédé permet de réaliser une cathode sans utiliser de masque (souple en résine pour la photolithographie ou rigide pour la technique employant des pochoirs).

De plus, le procédé permet de limiter le nombre d'étapes technologiques par rapport, notamment, à celles de la photolithographie.

Le procédé selon l'invention exploite la différence de propriétés mécaniques et thermomécaniques de couches cathodiques, d'une part, sur le substrat et, d'autre part, sur la couche métallique. De façon inattendue, il a été observé qu'en dehors des zones occupées par la couche métallique, sur le substrat, le dépôt de la couche cathodique est pulvérulent après l'étape du traitement thermique à haute température (typiquement à des températures supérieures ou égales à 400°C). La couche cathodique présente une très faible adhérence sur le substrat en céramique, en verre ou en silicium, contrairement à l'adhérence entre la couche cathodique et la couche métallique, ce qui engendre un décollement de la couche cathodique en dehors du motif métallique. Une simple opération de nettoyage permet de retirer la couche cathodique en dehors du motif métallique. On obtient un motif de cathode exclusivement et correctement positionné au-dessus de la couche métallique. La présente invention permet de localiser efficacement le dépôt de la cathode des microbatteries et limite le recours aux techniques de masquage de l'état de l'art.

Le traitement thermique permet, avantageusement, d'activer la couche cathodique pour améliorer ses propriétés électrochimiques, notamment en la cristallisant.

Avantageusement, le procédé comprend une étape ultérieure d) dans laquelle le substrat est nettoyé, par exemple par application d'un flux de gaz, afin de retirer la première partie de la couche cathodique.

Avantageusement, la couche métallique a une épaisseur allant de 100nm à 1µm et de préférence de 100nm à 300nm.

Avantageusement, la couche métallique est en titane, en or, en aluminium, en platine, en fer, en tungstène, en cuivre ou en un alliage de ces métaux.

Avantageusement, le substrat a une épaisseur allant de 10µm à 100µm et de préférence de 10µm à 20µm.

Avantageusement, le substrat est en zircone yttriée.

Avantageusement, la couche cathodique à une épaisseur allant de 10µm à 30µm et de préférence de 10µm à 25µm. Le procédé permet de réaliser des électrodes positives épaisses (typiquement ayant une épaisseur supérieure ou égale à 10µm).

Avantageusement, la couche cathodique est en LiCoO₂.

Avantageusement, la température du traitement thermique de l'étape c) va de 400°C à 800°C, et de préférence, de 500°C à 700°C.

Avantageusement, la durée du traitement thermique de l'étape c) va de 15 secondes à 24h, et de préférence de 1h à 10h, par exemple de 2h à 5h.

Avantageusement, la couche cathodique est déposée par pulvérisation cathodique.

L'invention concerne également un procédé de fabrication d'une microbatterie tout solide au lithium comprenant les étapes successives suivantes :
i. réalisation des étapes a) à c) telles que définies précédemment, de manière à former une électrode positive,
ii. formation d'une couche mince d'électrolyte solide sur l'électrode positive,
iii. formation d'une électrode négative sur la couche mince d'électrolyte
iv. formation d'un collecteur de courant anodique métallique, le collecteur de courant anodique étant en contact avec l'électrode négative.

Selon une première variante avantageuse, le procédé comprend une étape additionnelle entre l'étape i et l'étape ii dans laquelle un collecteur de courant cathodique, en contact avec l'électrode positive est formé.

Selon une deuxième variante avantageuse, le procédé comprend une étape additionnelle après l'étape i ou après l'étape iv dans laquelle la couche métallique est rendue accessible par gravure afin de réaliser une reprise de contact.

Selon une troisième variante avantageuse, des vias sont réalisés à travers le substrat de manière à réaliser une reprise de contact sur la couche métallique à travers le substrat.

### BRÈVE DESCRIPTION DES DESSINS

La présente invention sera mieux comprise sur la base de la description qui va suivre et des dessins en annexe sur lesquels:
- les figures 1 à 5 représentent, schématiquement, différentes étapes du procédé de fabrication d'une électrode positive, selon un mode de réalisation particulier de l'invention,
- les figures 6 et 7 représentent, de manière schématique différentes étapes du procédé de fabrication d'une microbatterie, selon un mode de réalisation particulier de l'invention,
- les figures 8A à 8D représentent, de manière schématique différentes étapes du procédé de fabrication d'une microbatterie, selon un mode de réalisation particulier de l'invention,

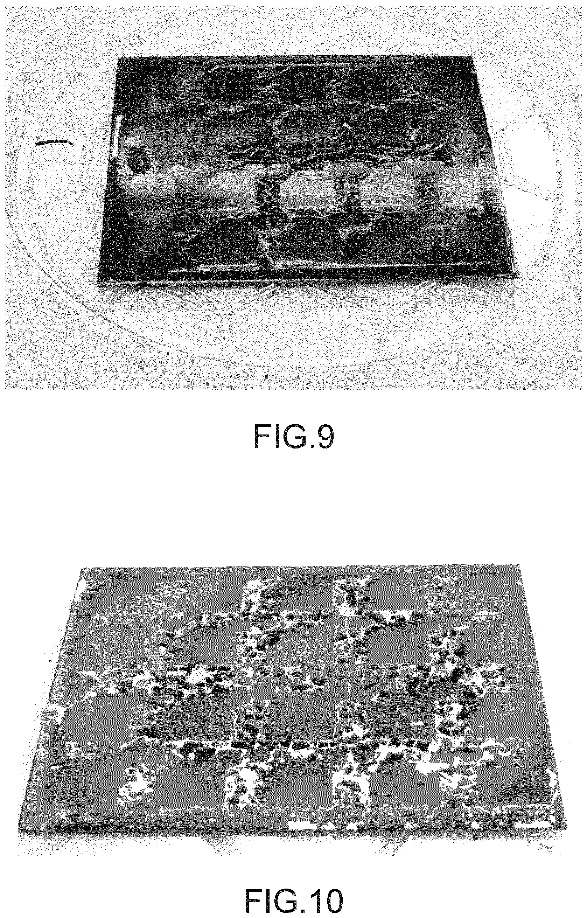

- la figure 9 est un cliché photographique représentant une couche de LiCoO₂ de 7µm d'épaisseur déposée sur un substrat recouvert localement par des couches métalliques, après traitement thermique, selon un mode de réalisation particulier de l'invention,
- la figure 10 est un cliché photographique représentant une couche de LiCoO₂ de 21µm d'épaisseur déposée sur un substrat recouvert localement par des couches métalliques, selon un mode de réalisation particulier de l'invention.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et pouvant se combiner entre elles.

### EXPOSÉ DÉTAILLÉ DE MODES DE RÉALISATION PARTICULIERS

Dans la description détaillée qui va suivre, donnée à titre illustratif et non limitatif, le procédé est principalement décrit pour réaliser une électrode positive 32 (cathode) en oxyde de cobalt pour microbatterie au lithium comprenant un substrat en céramique. Cependant, l'homme du métier pourra appliquer cet enseignement à d'autres matériaux de substrat et/ou d'électrode.

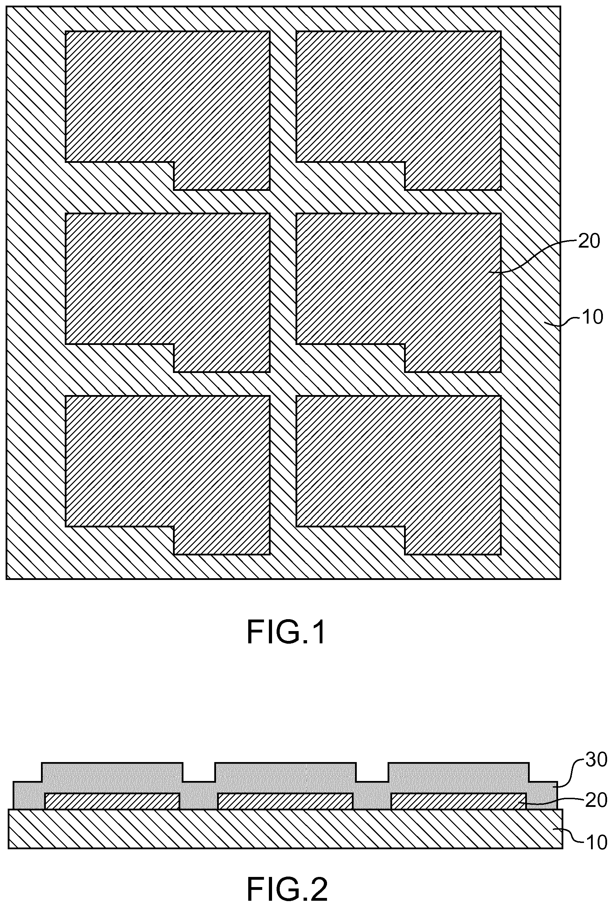

On se réfère, en premier, aux figures 1 à 5.

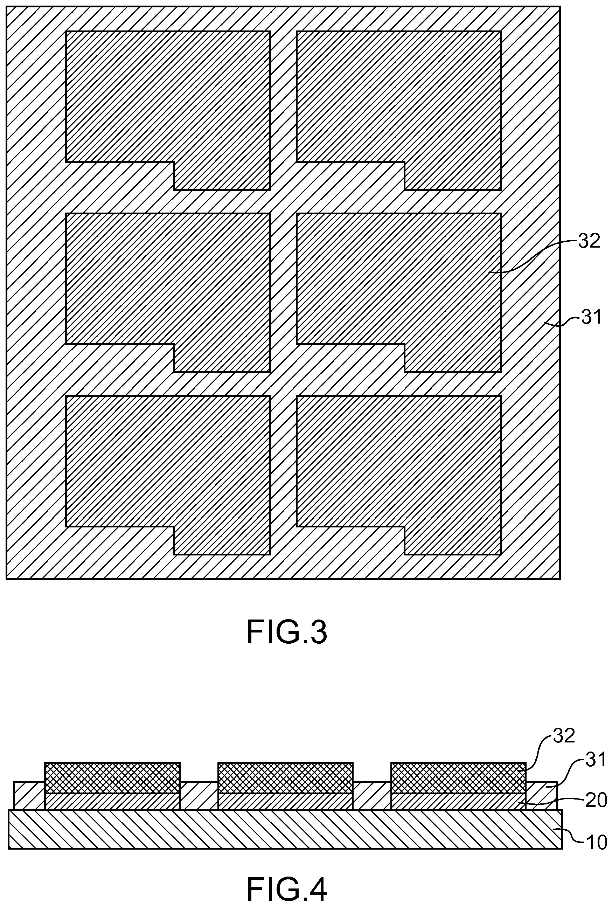

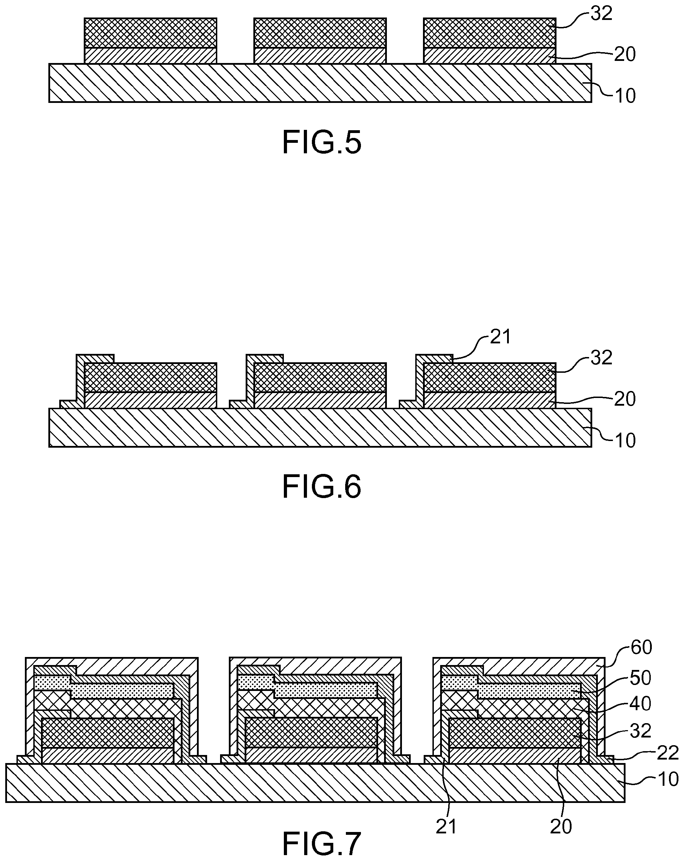

Le procédé de réalisation d'une électrode positive 32 pour microbatterie tout solide au lithium comprenant les étapes successives suivantes :
a) fourniture d'un substrat 10, typiquement fin ou ultrafin, en céramique, en verre ou en silicium, recouvert localement par une couche métallique 20, (figure 1)
b) dépôt d'une couche cathodique 30 en un matériau d'électrode positive, par exemple en oxyde mixte de lithium, la couche cathodique 30 ayant une épaisseur supérieure à 1µm, une première partie 31 de la couche cathodique 30 recouvrant le substrat 10 et une deuxième partie 32 de la couche cathodique 30 recouvrant la couche métallique 20, destinée à former l'électrode positive 32, (figure 2),
c) réalisation d'un traitement thermique à une température supérieure ou égale à 400°C, sur la couche cathodique 30, de manière à cristalliser la deuxième partie de la couche cathodique 30 pour former une électrode positive 32, et de manière à délaminer la première partie 31 de la couche cathodique 30, (figures 3 et 4),
d) de préférence, nettoyage du substrat 10, par exemple par application d'un flux de gaz, afin de retirer la première partie 31 de la couche cathodique 30 (figure 5).

### Le substrat 10 :

L'homme du métier choisira un substrat 10 adapté à la réalisation de microbatteries. Par exemple, le substrat 10 peut être en céramique, en silicium, ou en verre.

Le silicium peut être monocristallin ou polycristallin.

Le verre peut être choisi parmi les borosilicates (comme, par exemple, les références D263®LA, D263®M, D263®T, MEMpax® ou encore le Borofloat® commercialisés par la société SCHOTT®), les dérivés de borosilicates comme les verres de type « alkali-free borosilicates » (AF32®, AF45, Corning®Willow....) ou encore des verres de type boro-aluminosilicates (« alkaline earth boro-aluminosilcates ») commercialisés par exemple par les sociétés Corning Lotus™, EAGLE XG®.

De préférence, le substrat 10 en verre est transparent aux longueurs d'onde des lasers classiquement utilisés pour les étapes de découpe. Par transparent, on entend que le substrat 10 laisse passer au moins 50% de la lumière émise par le laser.

Le substrat 10 fourni à l'étape a) est, de préférence, un substrat 10 en céramique. De préférence il s'agit d'une zircone yttriée. Ce matériau présente des propriétés thermomécaniques adaptées au procédé. Le substrat 10 a, par exemple, un coefficient d'expansion thermique de 8x10⁻⁶/°C à température ambiante et un module de Young de 200 GPa. Il présente également une très bonne stabilité thermique à 1000°C, et un coefficient d'expansion thermique de 11x10⁻⁶/°C à 1000°C compatibles avec les procédés de réalisation des électrodes à haute température pour les microbatteries au lithium. Le substrat 10 présente initialement une contrainte résiduelle compressive de 250GPa à température ambiante (20-25°C).

Il s'agit d'un substrat 10 fin ayant une épaisseur inférieure à 100µm, ou d'un substrat 10 ultrafin ayant une épaisseur inférieure à 50µm. Le substrat 10 a, par exemple, une épaisseur de 20µm. Par exemple, le substrat 10 a une épaisseur allant de 10µm à 100µm et de préférence de 10µm à 20µm.

Par exemple, on pourra utiliser un substrat 10 en céramique de type « Thin E-Strate » commercialisée par la société ENrG d'une épaisseur de 20µm.

Le substrat 10 comprend une première face, une deuxième face et une face latérale. La deuxième face est opposée à la première face. La première face est recouverte par la couche métallique, il s'agit de la face dite avant ou face active. La deuxième face est la face arrière.

### La couche métallique 20 :

Comme représenté sur la figure 1, la première face du substrat 10 est recouverte localement par une couche métallique 20. Le substrat 10 est, de préférence recouvert par plusieurs couches métalliques, disposées dans un même plan parallèle à la surface du substrat 10. Les couches métalliques forment des ilots métalliques.

La couche métallique 20 est, de préférence, en contact direct avec le substrat 10. Il n'y a pas d'élément entre la couche métallique 20 et le substrat 10.

La couche métallique 20 est mécaniquement robuste afin de soutenir les autres couches qui vont être ultérieurement formées et ne pas impacter les propriétés mécaniques des couches supérieures.

La couche métallique 20 présente des contraintes en compression/tension très faibles (module de Young<500MPa) en comparaison aux autres éléments de la structure (substrat 10, cathode 32).

La couche métallique 20 est, par exemple, en titane, en or, en aluminium, en platine, en fer, en tungstène, en cuivre ou en un alliage de ces métaux. La couche métallique 20 peut également être un bicouche métallique. Elle pourrait également comprendre d'autres couches métalliques.

L'épaisseur de la couche métallique 20 va de quelques nanomètres à quelques micromètres. Elle a, par exemple, une épaisseur allant de 100nm à 1µm et de préférence de 100nm à 300nm.

Par exemple, la couche métallique 20 est un bicouche comprenant une couche de titane (par exemple de 50nm d'épaisseur) et une couche de platine (par exemple de 250nm d'épaisseur). Le rôle de la couche du titane est d'améliorer l'accrochage et l'adhésion de la couche du platine sur le substrat 10 en céramique. La couche de platine fournit les propriétés de résistance à l'oxydation sous l'effet du recuit thermique qui sont intrinsèquement meilleures que les propriétés d'une couche de titane seule. De plus, ces deux matériaux ont des propriétés mécaniques assez proches avec des coefficients d'expansion thermiques situés entre 8x10⁻⁶/°C et 9x10⁻⁶/°C et des modules de Young dans la gamme 100 à 200 GPa. De plus, la couche possède un stress résiduel intrinsèque relativement faible en comparaison avec le substrat 10 (typiquement inférieur à 1 GPa).

La couche métallique 20 peut être réalisée par des techniques classiques comme la pulvérisation cathodique ou le dépôt physique sous vide en utilisant les techniques de masquage mécanique (alternativement de photolithographie ou de laser) pour lui donner la forme souhaitée.

La couche métallique 20 peut être utilisée selon des configurations/motifs spécifiques délimitant les zones de dépôt de la couche cathodique 30.

Avantageusement, la couche métallique 20 peut jouer le rôle de collecteur de courant cathodique 21.

### La couche cathodique 30 :

Lors de l'étape b), une couche cathodique 30 est déposée sur le substrat 10 et sur la couche métallique 20 (figure 2).

La partie de la couche cathodique 30 déposée sur la couche métallique 20 est destinée, à former après le traitement thermique de l'étape c), l'électrode positive 32.

La couche cathodique 30 est en un matériau ayant une bonne conductivité électronique et ionique. On choisira, avantageusement, un matériau nécessitant un recuit thermique pour améliorer ses propriétés électrochimiques (activation).

Elle peut être en TiOS, V₂O₅, TiS₂, en un oxyde d'un métal de transition lithié tel que LiCoO₂, LiTiS₂, LiCoO₂, Li(Ni,Co,Mn)O₂ (NMC), ou Li(Ni, Co, Al)O₂ (NCA), ou encore en un phosphate de fer lithié ou un oxysulfure de titane lithié (LiTiOS). De préférence, elle est en LiCoO₂ qui présente de bonnes performances électrochimiques.

La couche cathodique 30 a, par exemple, une épaisseur conforme.

Elle a une épaisseur supérieure à 1µm et de préférence supérieure ou égale à 10µm pour former des électrodes dites épaisses. Elle a, par exemple, une épaisseur allant de 10µm à 30µm et de préférence de 10µm à 25µm.

La couche cathodique 30 peut être déposée par voie chimique, par dépôt chimique en phase vapeur ou par dépôt physique en phase vapeur (ou PVD pour « Physical Vapor Deposition »). Le dépôt peut être suivi d'un traitement thermique.

De préférence, la couche cathodique 30 est obtenue par pulvérisation cathodique à partir d'une cible. Cette technique consiste à appliquer une différence de potentiel entre les parois d'un réacteur et d'une cible (appelée cathode), située à l'intérieur du réacteur, de manière à ioniser l'atmosphère du réacteur et créer un plasma. Sous l'effet du champ électrique, les espèces positives du plasma (comme par exemple les ions Ar⁺) vont bombarder la cible. Les atomes qui sont éjectés de la cible se déposent sur un substrat 10. La couche déposée a une composition chimique identique ou proche de celle de la cible. Cette technique est particulièrement intéressante puisqu'elle permet d'obtenir des films minces à basse température et peut donc être employée sur tout type de substrat 10 (silicium, polymère, etc). Le chauffage thermique induit par le dépôt par pulvérisation reste relativement contenu dans des valeurs en dessous de 400°C.

Par exemple, après dépôt, la couche cathodique 30 en LiCoO₂ présente une contrainte résiduelle compressive dont les valeurs sont de l'ordre de quelques giga pascal ainsi qu'un module d'élasticité présentant des valeurs entre 100 et 300 GPa selon les conditions d'élaboration. De plus, elle a des coefficients d'expansion thermiques variant de 10x10⁻⁶/°C à 15x10⁻⁶/°C dans la gamme de température allant de 25 à 400°C. Les contraintes internes (valeur et gradient le cas échéant) dépend du matériau et de son procédé d'élaboration, en particulier des conditions physiques régissant la croissance des couches minces. De manière générale, les couches cathodiques préconisées dans le cadre de cette invention sont des oxydes de type LiₓM_{y}O_{z} (M étant un métal de transition comme le Fe, Mn, Co, Ni, Ta, Nb....). Ces matériaux pouvant être utilisés pour former l'électrode positive présentent comme avantage de contenir du lithium rendant possible l'utilisation d'un matériau non lithié en électrode négative. Pour l'électrode négative, il est possible d'employer au moins l'une des couches suivantes : LiMn₂O₄, LiFePO₄, LiTaO₃, LiNbO₃.... A titre d'exemple alternatif au LiCoO₂, une électrode en LiMn₂O₄ peut être déposée avec des techniques de pulvérisation cathodique et avec des températures de l'ordre de 600 °C à 700°C. La contrainte résiduelle de ce type de couche varie entre 100 et 150 GPa et son coefficient d'expansion thermique est de l'ordre de 10x10⁻⁶/°C. Cependant, l'oxyde métallique le plus couramment utilisé reste l'oxyde de cobalt lithié (LiCoO₂) pour ses propriétés électrochimiques et son procédé de mise en œuvre très avantageux par rapport à d'autres oxydes.

Les contraintes résiduelles de nature compressive induites par la formation de la couche cathodique 30 sur le substrat 10 conduisent à une légère délamination de cette partie de la couche en LiCoO₂. La couche tend à se courber vers le haut.

### Recuit thermique :

L'étape de dépôt de la couche cathodique 30 (étape b)) est suivie d'une étape de recuit thermique (étape c)) dont le but principal est de cristalliser la couche du LiCoO₂ et d'obtenir le comportement électrochimique désiré.

L'étape de recuit conduit en même temps à une totale et nette délamination de la partie 31 de la couche cathodique 30 qui se trouve en contact direct avec le substrat 10. Cette partie 31 de la couche présente un aspect pulvérulent, après le recuit thermique. La partie de la couche cathodique 30 en contact avec les couches métalliques ne subit pas ces déformations, elle demeure adhérente avec la couche métallique 20 et aboutit à la formation d'une électrode positive 32 (figures 3 et 4).

La durée du recuit va par exemple de 15 secondes à 5 heures. Elle peut être de 2h.

La température du recuit va par exemple de 400°C à 800°C, et de préférence, de 500°C à 700°C. Elle peut être de 600°C.

Le recuit peut être réalisé sous air.

L'étape de dépôt suivi de l'étape de recuit conduit à une auto-structuration de la couche cathodique 30. Le recuit thermique de cristallisation induit un gradient de contraintes sans avoir besoin de faire appel à des techniques supplémentaires (masquage). En effet, la combinaison des contraintes résiduelles intrinsèques et des contraintes résiduelles d'origine thermiques sont telles que les comportements mécaniques de la partie de la couche cathodique 30 formée sur le substrat 10 et la partie de la couche cathodique 30 formée sur la couche métallique 20 sont significativement différents. L'incompatibilité des dilatations thermiques et la différence des propriétés d'élasticité entre la couche et le substrat 10 créent un cyclage mécanique dans la couche cathodique 30 en LiCoO₂ qui peut se traduire par un relâchement des contraintes compressives et la couche finie par se recourber vers le bas. La perte d'adhésion entre la couche cathodique 30 et le substrat 10 en dehors des zones délimitées par la couche métallique 20 peut résulter d'une possible relaxation de la contrainte compressive sous l'effet du recuit thermique.

De façon générale, les gradients de contraintes peuvent entrainer une courbure non réversible des structures élaborées. Le rôle des couches métalliques est d'assurer une certaine réversibilité de la structure formée par le triplé substrat 10 / couche cathodique 30 / couche métallique 20 en amortissant les effets du relâchement des contraintes causées par les procédés du recuit thermique.

Le dépôt direct d'une couche cathodique 30 procure un comportement en tension de l'ensemble formé par le substrat 10 fin et les couches déposées (couche métallique 20 et cathode 32). En raison de l'épaisseur et des propriétés thermomécaniques intrinsèques de la couche cathodique 30, le recuit thermique alimenterait un effet compressif de l'ensemble substrat 10 fin et couches déposées. L'effet compressif engendré par le recuit thermique est beaucoup plus prépondérant pour des couches cathodiques épaisses (>10µm) et des substrats 10 ultrafins (<50µm). L'inversion du comportement (tension vers compression) de la structure formée par le substrat 10, la couche métallique 20 (dont le rôle principal est de servir de collecteurs de courant cathodique) et la couche cathodique 30 sous l'effet du recuit thermique engendre un décollement de la couche cathodique 30 disposée en contact direct avec la surface du substrat 10 fin en céramique à l'exception des zones protégées par des dépôts métalliques. Dans ce cas, le motif métallique fait office d'élément amortisseur en compensation des différences de contraintes thermomécaniques entre d'un côté la couche cathodique 30 et de l'autre côté le substrat 10 fin en céramique.

L'homme du métier choisira les différents paramètres de réalisation du procédé, telles que les caractéristiques du substrat 10 (épaisseur, coefficient d'expansion thermique), de la couche cathodique 30 (épaisseur, coefficient d'expansion thermique), et du traitement thermique (température, durée) en fonction des contraintes tensiles/compressives recherchées.

Les résidus pulvérulents de la partie de la couche 31 peuvent ensuite être éliminés avec un procédé de soufflage, par exemple sous air sec (figure 5).

Le procédé de fabrication d'une électrode positive 32 est, avantageusement, mis en œuvre pour fabriquer une microbatterie tout solide au lithium, comme représenté sur les figures 6 et 7 ainsi que 8A à 8D. Le procédé de fabrication de la microbatterie comprend les étapes successives suivantes :
i. réalisation des étapes a) à c) telles que définies précédemment, de manière à former une électrode positive 32,
ii. formation d'une couche mince d'électrolyte solide 40 sur l'électrode positive 32,
iii. formation d'une électrode négative 50 sur la couche mince d'électrolyte 40
iv. formation d'un collecteur de courant anodique 22 métallique, le collecteur de courant anodique 22 étant en contact avec l'électrode négative 50.

### La couche d'électrolyte solide 40 :

La couche d'électrolyte solide 40 est un matériau isolant électronique ayant une forte conductivité ionique. Par exemple, il s'agit d'une couche mince en LiPON (« Lithium Phosphorous OxyNitride »), LiSiPON (« Nitrogen-incorporated Lithium SilicoPhosphate »), LiSON («Lithium Sulfur Oxynitride »), LiPONB, ou LiSiCON (« Li Super lonic Conductor »).

Cette couche peut être formée par pulvérisation cathodique (PVD) pour obtenir une couche continue, de très faible épaisseur (par exemple de 1.5µm d'épaisseur), sans défauts. Elle peut être déposée à travers un jeu de masque dédié de manière à recouvrir la cathode 32, une partie du substrat 10 et une partie du collecteur cathodique.

### L'électrode négative 50 (anode) :

L'électrode négative 50 peut être du lithium métallique, du graphite, un alliage métallique à base de lithium, ou bien un composé d'insertion tel que Li₄Ti₅O₁₂.

L'électrode négative 50 peut être réalisée en lithium par évaporation sous vide secondaire en chauffant du lithium métallique. On obtient ainsi un film de lithium, dont l'épaisseur varie de 1 à 3 µm, disposée de manière à être en contact uniquement avec l'électrolyte. Afin d'assurer une meilleure circulation du courant anodique, un ou plusieurs niveaux de métallisation spécifiques peuvent être nécessaires.

### Le collecteur de courant anodique 22 :

Le collecteur de courant anodique 22 est, avantageusement, métallique et peut être, par exemple, à base de titane, de tungstène, de nickel, de platine, de cuivre ou d'or. Il pourrait également être en aluminium ou en cuivre ou en un mélange de plusieurs métaux.

Le collecteur de courant anodique 22 peut être déposé par pulvérisation cathodique à travers un masque (figure 7).

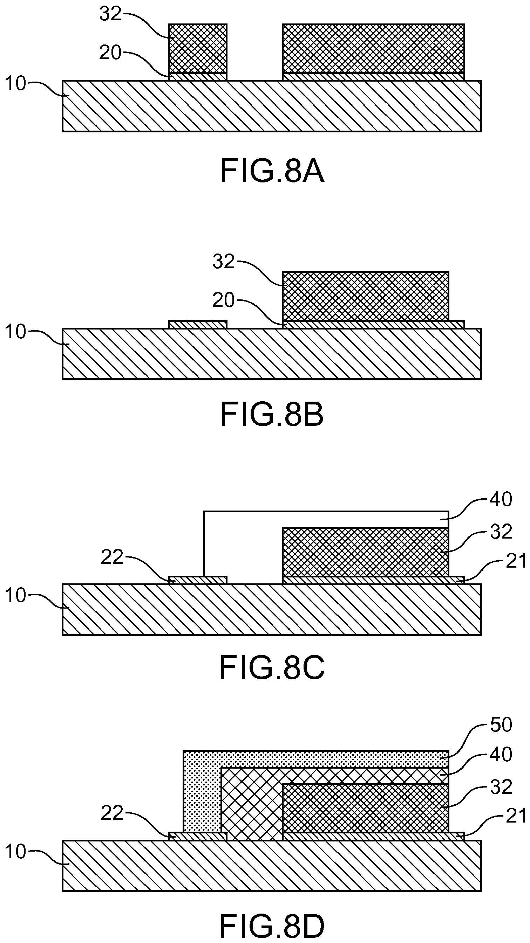

Une partie de la couche métallique 20 peut servir à former le collecteur de courant anodique 22 (figures 8A à 8D). Pour cela, on déposera plusieurs couches métalliques 20 sur le substrat 10. Après formation d'électrodes positives 32 sur les différentes couches métalliques 20, par le procédé tel que précédemment décrit (figure 8A), certaines électrodes seront gravées par toute technique adaptée, de manière à rendre accessibles certaines couches métalliques (figure 8B). Les couches métalliques recouvertes par les électrodes positives joueront le rôle de collecteur de courant cathodique 21 alors que autres couches métalliques joueront le rôle de collecteur de courant anodique 22 (figure 8D).

### Le collecteur de courant cathodique 21 :

L'électrode positive 32 est en contact avec un collecteur de courant cathodique 21. Le collecteur de courant peut être sur l'électrode positive 32 ou sous l'électrode positive 32.

Dans la première variante, le collecteur de courant recouvre localement l'électrode positive 32 (figures 6 et 7). On choisira un recouvrement tel qu'il permette de bénéficier d'une grande surface active de la couche cathodique 30 tout en laissant suffisamment de surface libre pour déposer ultérieurement l'électrolyte solide.

Pour obtenir une telle configuration, le procédé peut comprendre une étape additionnelle entre l'étape i et l'étape ii dans laquelle le collecteur de courant cathodique 21, en contact avec l'électrode positive 32 est formé.

La deuxième variante correspond au cas où la couche métallique 20 joue le rôle de collecteur de courant 22 (figures 8A à 8D).

La libération des contacts cathodique peut se faire en fin de procédé de réalisation des microbatteries avec des techniques d'ablation, par exemple par gravure laser, afin de faire une zone sur la couche métallique 20 permettant une reprise de contact en face avant.

Une telle configuration consiste à réaliser une étape additionnelle, après l'étape i ou après l'étape iv, dans laquelle la couche métallique 20 est rendue accessible par gravure afin de réaliser la reprise de contact.

L'étape d'ouverture des contacts cathodiques peut éventuellement être réalisée juste après la formation des couches cathodiques (figure 8B). La zone peut être obtenue après un flux laser (longueur d'onde dans le vert 530nm et une énergie entre 10 et 40µJ).

L'accès aux contacts cathodiques peut aussi se faire à travers le substrat 10, au niveau de la face arrière, par la création de vias traversant en fin de procédé de réalisation des microbatteries ou bien en amont des étapes de dépôt des différentes couches. Cette configuration, non représentée, offre la possibilité de réaliser des empilements fonctionnels par intégration 3D.

D'une façon générale, le matériau du collecteur de courant doit être un très bon conducteur électronique. Ainsi, nous pouvons utiliser un matériau de même nature que celui de la couche métallique 20 ou un matériau différent. Le collecteur de courant est, de préférence, métallique. Il est, par exemple, à base de titane, de tungstène, de nickel, de platine, de cuivre ou d'or.

Il a, par exemple, une épaisseur allant de 10 nm à 1000 nm et de préférence entre 100 et 500 nm.

On pourra utiliser un collecteur de courant cathodique 21 en platine d'une épaisseur de 250 nm.

Le collecteur de courant peut être obtenu par tout type de techniques de dépôt en couches minces comme la PVD avec une technique de masquage mécanique.

### La couche d'encapsulation 60 :

Les couches précédemment décrites, et notamment l'électrode négative 50 en lithium ainsi que les autres couches à base de lithium, peuvent être protégées de l'air, par une couche d'encapsulation 60 (figure 7).

La couche d'encapsulation 60 peut être obtenue par un dépôt localisé d'une alternance de couche de polymère, comme les acrylates ou les époxydes, et de couche en un matériau barrière, comme l'oxyde de nitrure ou l'alumine.

Les contacts électriques des microbatteries ne sont pas représentés sur les figures.

### Exemples illustratifs et non limitatifs d'un mode de réalisation :

La couche cathodique 30 a été obtenue en réalisant les étapes successives suivantes :
- réalisation d'une série de plots à partir d'un dépôt d'une couche métallique 20 d'une épaisseur de 300nm sur un substrat 10 hôte en céramique de 20µm d'épaisseur,
- réalisation d'un dépôt pleine plaque et sans masque d'une couche cathodique 30 en dioxyde de cobalt et de lithium (LiCoO₂) de 20µm d'épaisseur,
- réalisation des opérations de traitement thermique adaptées à l'épaisseur et la composition des électrodes en LiCoO₂ à une température supérieure à 400°C et de préférence supérieure à 600°C pendant une durée de 2h,
- réalisation d'une action de nettoyage du substrat 10 par application d'un flux d'air ou de gaz neutre afin de supprimer les résidus de la couche cathodique 30 qui se trouve en dehors des zones délimitées par le motif des plots métalliques 20.

## Revendications

1. Procédé de réalisation d'une électrode positive (32) pour microbatterie tout solide au lithium comprenant les étapes successives suivantes :
a) fourniture d'un substrat (10), en particulier en céramique, en verre ou en silicium, le substrat étant recouvert localement par une couche métallique (20),
b) dépôt d'une couche cathodique (30) en un matériau d'électrode positive, par exemple en oxyde mixte de lithium, la couche cathodique (30) ayant en particulier une épaisseur supérieure à 1µm, une première partie (31) de la couche cathodique (30) recouvrant le substrat (10) et une deuxième partie de la couche cathodique (30) recouvrant la couche métallique (20),
c) réalisation d'un traitement thermique à une température supérieure ou égale à 400°C, sur la couche cathodique (30), de manière à cristalliser la deuxième partie de la couche cathodique (30) pour former une électrode positive (32), et de manière à délaminer la première partie (31) de la couche cathodique (30).

2. Procédé selon la revendication 1, **caractérisé en ce qu'**il comprend une étape ultérieure d) dans laquelle, le substrat (10) est nettoyé, par exemple par application d'un flux de gaz, afin de retirer la première partie (31) de la couche cathodique (30).

3. Procédé selon l'une des revendications 1 et 2, **caractérisé en ce que** la couche métallique (20) a une épaisseur allant de 100nm à 1µm et de préférence de 100nm à 300nm.

4. Procédé selon l'une quelconque des revendications précédentes, **caractérisé en ce que** la couche métallique (20) est en titane, en or, en aluminium, en platine, en fer, en tungstène, en cuivre ou en un alliage de ces métaux.

5. Procédé selon l'une quelconque des revendications précédentes, **caractérisé en ce que** le substrat (10) a une épaisseur allant de 10µm à 100µm et de préférence de 10µm à 20µm.

6. Procédé selon l'une quelconque des revendications précédentes, **caractérisé en ce que** le substrat (10) est en zircone yttriée.

7. Procédé selon l'une quelconque des revendications précédentes, **caractérisé en ce que** la couche cathodique (30) a une épaisseur allant de 10µm à 30µm et de préférence de 10µm à 25µm.

8. Procédé selon l'une quelconque des revendications précédentes, **caractérisé en ce que** la couche cathodique (30) est un oxyde lithié à base d'un métal de transition et notamment en LiCoO₂.

9. Procédé selon l'une quelconque des revendications précédentes, **caractérisé en ce que** la température du traitement thermique de l'étape c) va de 400°C à 800°C, et de préférence, de 500°C à 700°C.

10. Procédé selon l'une quelconque des revendications précédentes, **caractérisé en ce que** la durée du traitement thermique de l'étape c) va de 15 secondes à 24 heures, et de préférence de 1 heure à 10 heures.

11. Procédé selon l'une quelconque des revendications précédentes, **caractérisé en ce que** la couche cathodique (30) est déposée par pulvérisation cathodique.

12. Procédé de fabrication d'une microbatterie tout solide au lithium comprenant les étapes successives suivantes :
i. réalisation des étapes a) à c) telles que définies dans la revendication 1, de manière à former une électrode positive (32),
ii. formation d'une couche mince d'électrolyte (40) solide sur l'électrode positive (32),
iii. formation d'une électrode négative (50) sur la couche mince d'électrolyte (40)
iv. formation d'un collecteur de courant anodique (22) métallique, le collecteur de courant anodique (22) étant en contact avec l'électrode négative (50).

13. Procédé selon la revendication 12, **caractérisé en ce qu'**il comprend une étape additionnelle entre l'étape i et l'étape ii dans laquelle un collecteur de courant cathodique (21), en contact avec l'électrode positive (32) est formé.

14. Procédé selon la revendication 12, **caractérisé en ce qu'**il comprend une étape additionnelle après l'étape i ou après l'étape iv dans laquelle la couche métallique (20) est rendue accessible par gravure afin de réaliser une reprise de contact.

15. Procédé selon la revendication 12, **caractérisé en ce que** des vias sont réalisés à travers le substrat (10) de manière à réaliser une reprise de contact sur la couche métallique (20) à travers le substrat (10).

## Patentansprüche

1. Verfahren zur Herstellung einer positiven Elektrode (32) für eine vollfeste Lithium-Mikrobatterie, umfassend die nachstehenden aufeinanderfolgenden Schritte:
a) Bereitstellen eines Substrats (10), insbesondere aus Keramik, Glas oder Silizium, wobei das Substrat bereichsweise mit einer Metallschicht (20) bedeckt ist,
b) Abscheiden einer Kathodenschicht (30) aus einem positiven Elektrodenmaterial, beispielsweise Lithium-Mischoxid, wobei die Kathodenschicht (30) insbesondere eine Dicke von mehr als 1 µm aufweist, ein erster Teil (31) der Kathodenschicht (30) das Substrat (10) bedeckt und ein zweiter Teil der Kathodenschicht (30) die Metallschicht (20) bedeckt,
c) Durchführen einer Wärmebehandlung bei einer Temperatur höher oder gleich 400°C an der Kathodenschicht (30), um den zweiten Teil der Kathodenschicht (30) zu kristallisieren, um eine positive Elektrode (32) zu bilden, und um den ersten Teil (31) der Kathodenschicht (30) zu delaminieren.

2. Verfahren nach Anspruch 1, **dadurch gekennzeichnet, dass** es einen nachträglichen Schritt d) umfasst, bei dem das Substrat (10) gereinigt wird, beispielsweise durch Anlegen eines Gasstroms, um den ersten Teil (31) der Kathodenschicht (30) zu entfernen.

3. Verfahren nach einem der Ansprüche 1 und 2, **dadurch gekennzeichnet, dass** die Metallschicht (20) eine Dicke von 100 nm bis 1 µm und vorzugsweise von 100 nm bis 300 nm aufweist.

4. Verfahren nach einem der vorstehenden Ansprüche, **dadurch gekennzeichnet, dass** die Metallschicht (20) aus Titan, Gold, Aluminium, Platin, Eisen, Wolfram, Kupfer oder einer Legierung dieser Metalle besteht.

5. Verfahren nach einem der vorstehenden Ansprüche, **dadurch gekennzeichnet, dass** das Substrat (10) eine Dicke von 10 µm bis 100 µm und vorzugsweise von 10 µm bis 20 µm aufweist.

6. Verfahren nach einem der vorstehenden Ansprüche, **dadurch gekennzeichnet, dass** das Substrat (10) aus yttriumhaltigem Zirkonoxid besteht.

7. Verfahren nach einem der vorstehenden Ansprüche, **dadurch gekennzeichnet, dass** die Kathodenschicht (30) eine Dicke von 10 µm bis 30 µm und vorzugsweise von 10 µm bis 25 µm aufweist.

8. Verfahren nach einem der vorstehenden Ansprüche, **dadurch gekennzeichnet, dass** die Kathodenschicht (30) aus einem lithiumhaltigen Oxid auf Basis eines Übergangsmetalls und insbesondere LiCoO₂ ist.

9. Verfahren nach einem der vorstehenden Ansprüche, **dadurch gekennzeichnet, dass** die Temperatur der Wärmebehandlung in Schritt c) im Bereich von 400°C bis 800°C und vorzugsweise von 500°C bis 700°C liegt.

10. Verfahren nach einem der vorstehenden Ansprüche, **dadurch gekennzeichnet, dass** die Dauer der Wärmebehandlung in Schritt c) 15 Sekunden bis 24 Stunden, vorzugsweise 1 Stunde bis 10 Stunden, beträgt.

11. Verfahren nach einem der vorstehenden Ansprüche, **dadurch gekennzeichnet, dass** die Kathodenschicht (30) durch Kathodenzerstäubung abgeschieden wird.

12. Verfahren zur Herstellung einer vollfesten Lithium-Mikrobatterie, umfassend die nachstehenden aufeinanderfolgenden Schritte:
i. Ausführen der Schritte a) bis c) nach Anspruch 1 zur Bildung einer positiven Elektrode (32),
ii. Bilden einer dünnen Schicht eines Festelektrolyten (40) an der positiven Elektrode (32),
iii. Bilden einer negativen Elektrode (50) an der dünnen Elektrolytschicht (40),
iv. Bilden eines metallischen Anodenstromkollektors (22), wobei der Anodenstromkollektor (22) in Kontakt mit der negativen Elektrode (50) steht.

13. Verfahren nach Anspruch 12, **dadurch gekennzeichnet, dass** es einen zusätzlichen Schritt zwischen Schritt i und Schritt ii umfasst, bei dem ein Kathodenstromkollektor (21) in Kontakt mit der positiven Elektrode (32) gebildet wird.

14. Verfahren nach Anspruch 12, **dadurch gekennzeichnet, dass** es einen zusätzlichen Schritt nach Schritt i oder nach Schritt iv umfasst, bei dem die Metallschicht (20) durch Ätzen zugänglich gemacht wird, um eine erneute Kontaktierung herzustellen.

15. Verfahren nach Anspruch 12, **dadurch gekennzeichnet, dass** Durchkontaktierungen durch das Substrat (10) hergestellt werden, so dass eine erneute Kontaktierung an der Metallschicht (20) durch das Substrat (10) hindurch erfolgt.

## Claims

1. Method for producing a positive electrode (32) for a solid-state lithium microbattery comprising the following successive steps:
a) supplying of a substrate (10), typically made of ceramic, glass or silicon, the substrate being locally covered with a metal layer (20),
b) depositing of a cathodic layer (30) made of a positive electrode material, for example a mixed lithium oxide, the cathodic layer (30) having a thickness typically greater than 1µm, a first portion (31) of the cathodic layer (30) covering the substrate (10) and a second portion of the cathodic layer (30) covering the metal layer (20),
c) carrying out of a heat treatment at a temperature greater than or equal to 400°C, on the cathodic layer (30), in such a way as to crystallise the second portion of the cathodic layer (30) in order to form a positive electrode (32), and in such a way as to delaminate the first portion (31) of the cathodic layer (30).

2. Method according to claim 1, **characterized in that** it comprises a subsequent step d) in which the substrate (10) is cleaned, for example by application of a flow of gas, in order to remove the first portion (31) of the cathodic layer (30).

3. Method according to one of claims 1 and 2, **characterized in that** the metal layer (30) has a thickness ranging from 100nm to 1µm and preferably from 100nm to 300nm.

4. Method according to any one of the preceding claims, **characterized in that** the metal layer (20) is made of titanium, gold, aluminium, platinum, iron, tungsten, copper or an alloy of these metals.

5. Method according to any one of the preceding claims, **characterized in that** the substrate (10) has a thickness ranging from 10µm to 100µm and preferably from 10µm to 20µm.

6. Method according to any one of the preceding claims, **characterized in that** the substrate (10) is made of yttriated zirconia.

7. Method according to any one of the preceding claims, **characterized in that** the cathodic layer (30) has a thickness ranging from 10µm to 30µm and preferably from 10µm to 25µm.

8. Method according to any one of the preceding claims, **characterized in that** the cathodic layer (30) is made of a lithiated transition metal oxide and in particular made of LiCoO₂.

9. Method according to any one of the preceding claims, **characterized in that** the temperature of the heat treatment of the step c) ranges from 400°C to 800°C, and preferably, from 500°C to 700°C.

10. Method according to any one of the preceding claims, **characterized in that** the duration of the heat treatment of the step c) ranges from 15 seconds to 24 hours, and preferably from 1h to 10h.

11. Method according to any one of the preceding claims, **characterized in that** the cathodic layer (30) is deposited by cathodic sputtering.

12. Method of manufacturing a solid-state lithium microbattery comprising the following successive steps:
i. carrying out of the steps a) to c) such as defined in claim 1, in such a way as to form a positive electrode (32),
ii. forming of a thin layer of solid electrolyte (40) on the positive electrode (32),
iii. forming of a negative electrode (50) on the thin layer of electrolyte (40),
iv. forming of a metal anodic current collector (22), the anodic current collector (22) being in contact with the negative electrode (50).

13. Method according to claim 12, **characterized in that** it comprises an additional step between the step i and the step ii in which a cathodic current collector (21), in contact with the positive electrode (32) is formed.

14. Method according to claim 12, **characterized in that** it comprises an additional step after the step i or after the step iv in which the metal layer (20) is rendered accessible by etching in order to carry out a resuming of contact.

15. Method according to claim 12, **characterized in that** vias are carried out through the substrate (10) in such a way as to carry out a resuming of contact on the metal layer (20) through the substrate (10).
